# EUROPÄISCHE PATENTSCHRIFT

(11) **EP 2 210 132 B1**
(45) Veröffentlichungstag und Bekanntmachung des Hinweises auf die Patenterteilung: **10.08.2016**
(21) Anmeldenummer: 08841092.3
(22) Anmeldetag: 15.10.2008
(51) Int. Cl.: G02B 3/00, G02B 27/00, H01L 27/146

(54) **MIKROLINSEN-ARRAY MIT INTEGRIERTER BELEUCHTUNG**
ARRAY OF MICROLENSES WITH INTEGRATED ILLUMINATION
RÉSEAU DE MICROLENTILLES À ÉCLAIRAGE INTÉGRÉ

(30) Priorität: 19.10.2007 DE 102007050167
(43) Veröffentlichungstag der Anmeldung: 28.07.2010
(73) Patentinhaber: Fraunhofer-Gesellschaft zur Förderung der angewandten Forschung e.V., 80686 München (DE)
(72) Erfinder: SCHMÄLZLE, Philipp, Los Altos 94024 CA (US); DUPARRÉ, Jacques, 07745 Jena (DE); PUNKE, Martin, 88441 Mittelbiberach (DE); DANNBERG, Peter, 07745 Jena (DE); VÖLKEL, Reinhard, CH-2000 Neuchâtel (CH); BRÄUER, Andreas, 07646 Schlöben (DE)
(74) Vertreter: Pfenning, Meinig & Partner mbB
(86) Internationale Anmeldenummer: PCT/EP2008/008734
(87) Internationale Veröffentlichungsnummer: WO 2009/052980

(56) Entgegenhaltungen:
- WO-A-2007/082781
- US-A- 5 808 986

## Beschreibung

Die Erfindung betrifft ein Mikrolinsenarray mit integrierter Beleuchtung, ein Abbildungssystem mit einem solchen Mikrolinsenarray, eine Bilderfassungsvorrichtung sowie ein Verfahren zur Herstellung des Mikrolinsenarrays.

Für viele Anwendungen ist es wünschenswert, ein sehr nahes, näherungsweise ebenes Objekt mit einem kompakten, insbesondere axial kompakten (also kurzen) Abbildungssystem auf einen Bildsensor abzubilden. Um einen hohen Informationsgehalt zu erzielen, sind wünschenswerte Eigenschaften der optischen Abbildung eine geringe Beeinträchtigung durch Abberationen und Beugungseffekte, ein großes Objektfeld und ein nicht zu kleiner transversaler Abbildungsmaßstab (m ≥ 1, also 1:1 oder vergrößernd), um die durch Pixelierung gegebene Auflösungsgrenze eines gegebenen Bildsensors zur Objektabtastung möglichst gut auszunutzen.

Bei "konventionellen Optiken" (damit sollen im Folgenden stets einkanalige Optiken bezeichnet werden) ist hierfür beträchtlicher Bauraum senkrecht zur Objektebene (hier als z-Richtung oder axialer Richtung bezeichnet) erforderlich. Wenn ein in transversaler Richtung erweitertes Objektfeld gefordert wird, muss der Bauraum in z-Richtung ebenfalls vergrößert werden oder es muss ein stärkerer Einfluss von Bildfehlern hingenommen werden. In beiden Fällen erfordert die Skalierung des Objekt- und Bildfeldes beträchtlichen zusätzlichen Aufwand, da das Optikdesign überarbeitet werden muss und in der Regel andere Komponenten für die Abbildungsoptik verwendet werden müssen.

Bei "parallelen Optiken", die insbesondere mit Mikrolinsenarrays sehr vorteilhaft realisierbar sind, ist der in z-Richtung erforderliche Bauraum unabhängig von der Größe des Objektfeldes. Eine kompakte, insbesondere axial kompakte ("kurze") Bauform, ist damit möglich. Werden spezielle Array-Optik-Kriterien (die über die üblichen Bewertungskriterien für optische Abbildungssysteme hinausgehen) bei der Gestaltung der parallelen optischen Elemente berücksichtigt, kann eine Erweiterung des Objektfeldes durch bloßes Aneinanderreihen weiterer Elemente erzielt werden. Dieses günstige Skalierungsverhalten ist insbesondere bei Abbildungssystemen mit der transversalen Vergrößerung m = 1 (im Folgenden als 1:1 -Abbildungssysteme bezeichnet) erreichbar.

Optiken mit flachen Bauformen (kurzer Systemlänge in z-Richtung), werden häufig aus praktischen Gründen bevorzugt. Für gute Abbildungseigenschaften (z.B. hinsichtlich Lichtstärke, Auflösungsvermögen, etc.) ist es dann erforderlich, gleichfalls kurze Arbeitsabstände zwischen Objekt und Optik vorzusehen, wobei "kurz" bezogen auf die Systemlänge aufgefasst werden soll.

Wird ein geringer Abstand zwischen einem abzubildenden Objekt und der Optik angestrebt, so kommt der Beleuchtung des Objektes eine besondere Bedeutung zu. Für selbstleuchtende Objekte und für lichtdurchlässige Objekte ist die Beleuchtung weitgehend unproblematisch. Normalerweise wird hier eine geeignete Hintergrundbeleuchtung auf der der Optik abgewandten Seite des Objektes angeordnet.

Bei nicht-selbstleuchtenden und nicht transparenten Objekten hingegen kann die Beleuchtung nur durch Auflicht erfolgen. Gerade bei einer großen Objektfläche und einem geringen Abstand zwischen Objekt und Optik ist eine solche Auflichtbeleuchtung jedoch problematisch.

Zu den Standardmethoden der Auflichtbeleuchtung zählt die Beleuchtung von der Seite her. Eine solche ist jedoch schlecht skalierbar und führt zu einer inhomogenen Beleuchtungsintensität mit abnehmender Lichtstärke zur Mitte des Objekts hin.

Eine andere Standardmethode besteht darin, Licht über halbdurchlässige Spiegel einzuspiegeln. Soll jedoch der Abstand zwischen Objekt und Optik gering gehalten werden, so ist eine solche Beleuchtung von Nachteil.

Die US 6,987,259 beschreibt die Anordnung von Beleuchtungselementen in der Ebene der Detektorelemente (also bildwärts der Optik).

Direkte oder reflektierte Pfade zwischen Beleuchtungselementen und Detektorelementen sind in dieser Anwendung schwierig zu vermeiden, da der Beleuchtungsstrahlengang alle Elemente der Abbildungsoptik durchquert. Sind solche Pfade vorhanden, leidet die Bildqualität erheblich. Darüber hinaus erlaubt die Anordnung nur eine Beleuchtung mit in die Objektebene projiziertem Licht (critical illumination).

Die WO 2007/082781 A1 beschreibt ein Bilderfassungssystem, das nebeneinander angeordnete optische Kanäle aufweist, denen jeweils eine Mikrolinse und zumindest ein in der Bildebene angeordneter Detektor zugeordnet ist. Dabei sind die Detektoren derart angeordnet, dass die Richtungen der optischen Achse eine Funktion der Position des entsprechenden Kanals sind.

Die US 5,808,986 beschreibt ein optisches Speichersystem, das mehrere Lese-/Schreibstrahlen von Festkörperlasern zum simultanen Lesen bzw. Schreiben einer Vielzahl von Spuren auf optischen Medien erlaubt.

Die Erfindung soll daher folgende Aufgaben lösen. Es soll die Abbildung eines flächig ausgedehnten Objektes möglich sein, ohne die Optik relativ zum Objekt, zum Bildsensor oder zu beiden bewegen zu müssen. D.h. ein scannen des Objektes soll vermieden werden. Dieser Aufbau soll möglichst flach sein. Darüber hinaus soll dass Abbildungssystem und die Optik mit möglichst wenigen Komponenten herstellbar sein, um wirtschaftlich zu sein. Insbesondere soll die Zahl der zueinander zu justierenden Komponenten gering sein und jede der Komponenten soll aus einer möglichst geringen Anzahl separat herzustellender Schichten aufgebaut sein. Dennoch soll eine möglichst homogene Beleuchtung ermöglicht werden, die unabhängig von der Skalierung des Objektes und der Abbildungsoptik homogen ist.

Diese Aufgaben werden gelöst durch das Mikrolinsenarray nach Anspruch 1 und das Verfahren zur Herstellung des Mikrolinsenarrays nach Anspruch 13. Die jeweiligen abhängigen Ansprüche geben vorteilhafte Weiterbildungen der in den unabhängigen Ansprüchen gegebenen Gegenstände an.

Die Erfindung betrifft zunächst ein Mikrolinsenarray. Dieses weist einen optisch transparenten Grundkörper auf, auf, an oder in dessen einer Seite eine Vielzahl von Mikrolinsen angeordnet sind. Diese Mikrolinsen können auf dem Grundkörper befestigt, stoffschlüssig mit ihm verbunden oder in den Grundkörper integriert sein. Insbesondere können die Mikrolinsen auch zwischen den beiden Flächen des Grundkörpers angeordnet sein. In diesem Fall wären die Mikrolinsen hinter der ersten Seite des Grundkörpers angeordnet.

Erfindungsgemäß weist das Mikrolinsenarray außerdem zumindest eine Lichtquelle auf, welche an, in oder auf dem flächigen optisch transparenten Grundkörper angeordnet ist. Die zumindest eine Lichtquelle ist hierbei so angeordnet, dass ihre Projektion in Richtung der optischen Achsen der Mikrolinsen des Mikrolinsenarrays auf die erste Seite des Grundkörpers zwischen den Mikrolinsen liegt. Die Mikrolinsen sind hierzu voneinander beabstandet. Es is eine Vielzahl von Lichtquellen entsprechend angeordnet, die an verschiedenen Stellen zwischen den Mikrolinsen hindurch leuchten. Die Haupt-Lichtabstrahlrichtung der Lichtquellen liegt dabei im Wesentlichen parallel zu den bzw. nahe um die optischen Achsen der Mikrolinsen und in Richtung des abzubildenden Objektes.

Um einen Teil der "Grundfläche" des Arrays für Beleuchtungselemente übrig zu lassen, sind also vorzugsweise zwischen den freien Öffnungen der Mikrolinsen- bzw. Blendenarrays (nachfolgend verallgemeinernd als Abbildungs-Kanäle bezeichnet), Flächen vorgesehen, die nicht für den Durchgang von Abbildungs-Strahlengängen vorgesehen sind. Dadurch ergibt sich i. d. R. ein reduzierter Füllfaktor (genommen als Flächenquotient der freien Öffnungen zur Arrayfläche).

Störende Rückreflexionen des Auflichts (z.B. an Substratrückseiten) können hierbei durch die erfindungsgemäße freie Gestaltbarkeit der leuchtenden Teilflächen (z.B. durch Strukturierungsverfahren) unterdrückt werden. Dazu werden Mindestabstände zwischen Abbildungs-Aperturen und Beleuchtungselementen eingehalten, welche in der Regel von dem axialen Abstand zwischen den Beleuchtungselementen und relevanten (teil-)reflektierenden Flächen abhängig sind.

Die Wirkungsweise dieser Technik zur Falschlicht-Unterdrückung beruht darauf, Rückreflexions-Strahlen, welche die Abbildungs-Aperturen schneiden, nur unter größeren Einfallswinkeln (zur Flächennormalen) als dem maximalen Akzeptanzwinkel der Optik an diesem Ort zuzulassen.

Vorzugsweise sind die Lichtquellen auf der gleichen Seite des optisch transparenten Grundkörpers oder auf jener der die Mikrolinsen tragenden Seite gegenüber liegenden Seite des Grundkörpers angeordnet.

Für bestimmte Anwendungen kann der Grundkörper und damit das Mikrolinsenarray gekrümmt sein. Erfindungsgemäß erstreckt sich der transparente Grundkörper in einer Ebene. Diese Ebene wird normalerweise parallel zu den Linsenebenen der Mikrolinsen liegen.

Alle Mikrolinsen und/oder alle Lichtquellen oder jeweils alle Mikrolinsen und jeweils alle Lichtquellen haben bevorzugt im Wesentlichen die gleichen Abmessungen. Insbesondere können die Abmessungen der Lichtquellen mit jenen der Mikrolinsen übereinstimmen.

Für eine gleichmäßige und homogene Abbildung ist es bevorzugt, wenn die Lichtquellen und/oder die Mikrolinsen in einem Raster angeordnet sind. Dieses Raster kann rechteckig mit zueinander senkrechten Zeilen und Spalten nebeneinander sein oder es kann auch hexagonal sein. Die Lichtquellen können in den gleichen Zeilen und/oder Spalten wie die Mikrolinsen angeordnet sein, sie können aber auch in jeweils zwischen den Zeilen und/oder Spalten der Mikrolinsen eingeschobenen Zeilen und/oder Spalten angeordnet sein.

Um eine flache Baugröße zu ermöglichen, ist vorzugsweise die axiale Ausdehnung des Mikrolinsenarrays mit dem Grundkörper gegenüber der lateralen Kantenlänge von Mikrolinsenarray bzw. Grundkörper sehr klein. Unter der axialen Ausdehnung oder Baulänge wird hierbei die Ausdehnung in einer Richtung parallel zu den optischen Achsen der Mikrolinsen oder in einer Richtung senkrecht zur Ebene des Mikrolinsenarrays oder des Grundkörpers verstanden. Unter der lateralen Ausdehnung wird jene Ausdehnung in einer Richtung parallel zur Linsenebene der Mikrolinsen oder der Ebene des Mikrolinsenarrays bzw. des Grundkörpers verstanden. Eine geringe axiale Baulänge bedeutet also, dass das Mikrolinsenarray sehr flach ist. Vorzugsweise ist auch die gesamte optische Anordnung, also das vollständige Abbildungssystem, insbesondere mit eventuell vorhandenen Detektorelementen, sehr flach im obigen Sinne.

Besonders bevorzugt ist es, wenn eine, mehrere oder alle der Lichtquellen Lichtemitter zwischen zwei Elektroden besitzen, eine organische Leuchtdiode und/oder eine organische Lumineszenzdiode aufweisen.

Die Lichtquellen können insbesondere als organische Leucht- oder Lumineszenzdioden Polymere und/oder Small Molecules aufweisen oder daraus bestehen. Diese können im Wafer-Maßstab hergestellt werden. Auch EL-Folien, QuantumDot-LEDs und Lichtleiter (wie als Display-Backlights) kommen in Frage. Vorzugsweise sind zumindest die Lichtquellen eines Mikrolinsenarrays parallel herstellbar und/oder können auf großen Flächen im Wafer-Maßstab erzeugt werden. Um die Messung der spektralen Reflexionseigenschaften einer Objektoberfläche zu ermöglichen, können zumindest zwei Lichtquellen des Mikrolinsenarrays unterschiedliche Emissionsspektren haben.

Insbesondere kann zumindest ein Teil der Lichtquellen einen Teil oder ihre gesamte abgegebene Strahlung in einem Spektralbereich außerhalb des sichtbaren Lichts emittieren. Dies erlaubt die Bestimmung spektraler Reflexionseigenschaften einer Objektoberfläche in einem nicht-visuellen Spektralbereich. Auch Lichtanregung (Fluoreszenz) mit blauen oder UV-OLEDs ist möglich.

In aller Regel ist die direkte Abstrahlung der Beleuchtungselemente nur in Richtung des Objektes erwünscht, während eine direkte Abstrahlung in Richtung des Bildsensors als Falschlicht unterdrückt werden muss.

In Abbildungssystemen mit integrierter Beleuchtung ist es daher wichtig, den Anteil des erzeugten Lichtstroms, der den Bildsensor ohne die beabsichtigte Streuung am Objekt erreicht, zu minimieren. Andernfalls wird ein kontrastvermindernder Falschlicht-Einfluss nachteilig wirksam. Hierzu ist es vorteilhaft, die Beleuchtungselemente durch lichtundurchlässige Materialien von den Abbildungskanälen optisch zu isolieren. Dies kann durch eine geeignete Strukturierung der Beleuchtungselemente erreicht werden, die dann nur innerhalb bestimmter Teilflächen emittieren.

Für eine kostengünstige und einfache Herstellung ist es bevorzugt, wenn die zumindest eine Lichtquelle flächig ausgebildet ist und nur in rasterartig angeordneten Zonen Licht-emittierend wirkt. Derartige Zonen können beispielsweise durch rasterartige Blenden oder durch Entfernen von Teilen der Lichtquellenschicht, oder wenigstens einer der beiden Elektroden hergestellt werden.

Um zu erreichen, dass die Abstrahlung der Lichtquelle sich um eine Richtung parallel zur optischen Achse der Mikrolinsen in Richtung des Objektes konzentriert, kann die Lichtquelle von einer Blendenschicht umgeben sein, die sich in einer Ebene parallel zu ihrer Lichtaustrittsfläche erstreckt. Diese Blendenschicht ist lichtundurchlässig mit Ausnahme eines in Richtung des Objektes geöffneten Raumwinkelbereichs und in der Projektionsfläche der Mikrolinsen entlang ihrer optischen Achse.

Die Blendenschicht kann gleichzeitig entweder undurchsichtige Elektrodenschicht oder Isolatorschicht sein, beide Typen von Blendenschicht können gleichzeitig in einer Lichtquelle (vorder- und rückseitig) zur Anwendung kommen. Strukturierte Öffnungen in den Blendenschichten können den Lichtaustritt zur Beleuchtung des Objektes erlauben (in diesem Fall nicht die Elektrode, da sonst an dieser Stelle kein Licht erzeugt würde, die objektseitige Elektrode sollte in diesem Fall durchsichtig sein) oder Licht kann durch die Abbildungskanäle austreten. D.h. auch, dass neben der durchsichtigen Elektrode auch die (OLED-)Lichtemissionsschicht nicht notwendigerweise strukturiert sein muss, sondern durchgehend sein kann und nur an den Stellen lichtemittierend wirkt, an denen durch Strukturierung beidseitig von ihr Elektroden vorhanden sind (kein "strukturierter Emitter", sondern "strukturierter Stromfluss").

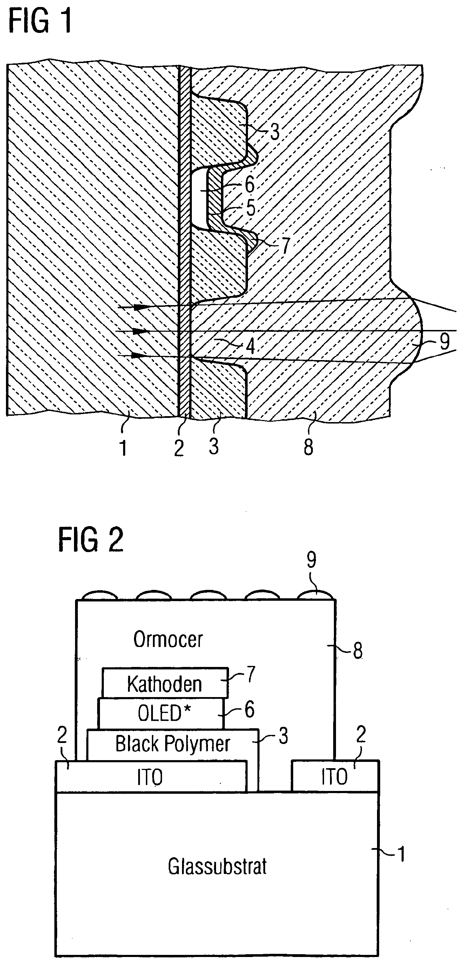

Der Aufbau ist beispielhaft in Figur 1 dargestellt. Die Kennziffer 3 zeigt die hier beschriebene Blendenstruktur.

Weist das Mikrolinsenarray zumindest zwei Lichtquellen auf, so kann sich eine derartige Blendschicht zwischen diesen erstrecken. Eine solche ist insbesondere sinnvoll, um zu vermeiden, dass Streulicht das Abbildungsergebnis und den Kontrast verschlechtert. Die Blendschicht weist vorzugsweise elektrisch nicht leitende, strukturierbare und/oder Licht-absorbierende Materialien auf oder besteht daraus. Insbesondere kommt für die Blendschicht ein Black-Matrix-Polymer mit einem hohen Volumenwiderstand in Frage.

Um eine Störung durch Streulicht zu vermeiden, kann außerdem der Grundkörper so dünn ausgeführt sein, dass das von den Lichtquellen emittierte Licht nach einmaliger Totalreflexion an der objektseitigen Grenzfläche des optisch transparenten Grundkörpers nicht in eine benachbarte Mikrolinse einfallen kann.

Es ist bevorzugt, dass die zumindest eine Lichtquelle des Mikrolinsenarrays durch zumindest eine Anode und zumindest eine Kathode als Elektroden kontaktiert wird. Diese Elektroden können Teil eines Rasters sein oder einzelnen angeordnet sein. Besonders vorteilhaft ist es, wenn die Anode oder die Kathode lichtundurchlässig ist und so angeordnet ist, dass die durch sie kontaktierte Lichtquelle von der Anode bzw. der Kathode in Richtung der Detektorelemente lichtundurchlässig abgeschirmt ist. Auch hierdurch wird verhindert, dass Streulicht auf einen eventuell vorhandenen Detektor trifft und damit das Abbildungsergebnis und den Kontrast verschlechtert. Die Aufgabe der Abschattung unerwünschten Streulichts und der elektrischen Kontaktierung der Lichtquellen kann durch die selben Bauelemente bewerkstelligt werden, wenn die Lichtquelle auf ihrer einen Seite von einer lichtdurchlässigen Elektrode aus elektrisch leitfähigem Material kontaktiert wird und auf der dieser gegenüber liegenden Seite von einer lichtundurchlässigen Elektrode aus elektrisch leitfähigem Material kontaktiert wird. Die lichtdurchlässige Elektrode ist dann zwischen dem optisch transparenten Grundkörper und der Lichtquelle angeordnet und die lichtundurchlässige Elektrode ist auf der dem Grundkörper abgewandten Seite der Lichtquelle angeordnet. Eine bildseitig angeordnete Elektrode dient hierbei also als lichtundurchlässige Blendschicht, um Lichtabstrahlung in Richtung der Bildseite zu verhindern. Unter der Bildseite des Mikrolinsenarrays wird hierbei jene einem aufzunehmendem Objekt abgewandte Seite verstanden, während unter der Objektseite jene dieser gegenüber liegende, dem Objekt zugewandte Seite des Mikrolinsenarrays verstanden wird.

Für die transparenten Elektroden kommt insbesondere Indium-Zinn-Oxid (ITO) in Frage. Dieses kann als Schicht auf der den Mikrolinsen abgewandten und/oder der die Mikrolinsen tragenden ersten Seite des Mikrolinsenarrays bzw. des Grundkörpers angeordnet sein.

Die Spannungsversorgung, d.h. die elektrische Ansteuerung, der einzelnen Lichtquellen kann einfach herstellbar einzeln nach einem Aktivmatrixverfahren oder nach einem Passivmatrixverfahren erfolgen und/öder sie kann gruppenweise in Blöcken und/oder in Streifen erfolgen.

Der optisch transparente Grundkörper kann Glas, glasartiges Material, Kunststoff, UV-härtbares Polymer und/oder UV-härtbares anorganisch-organisches Hybrid-polymer aufweisen oder daraus bestehen. Ein solches ist beispielsweise ORMOCER^{®}.

Vorzugsweise enthält der optische transparente Grundkörper ein Material, welches eine Strukturierung seiner optischen Eigenschaften, insbesondere seiner Absorption, zulässt, oder besteht aus diesem.

Durch das Material des Grundkörpers können dessen optische Eigenschaften, wie z.B. seine Absorption, gesteuert werden.

Die Mikrolinsen können alle oder zum Teil sphärische und/oder asphärische Linsen sein. In Frage kommen auch Zylinderlinsen, elliptische Linsen, Halbkugellinsen, konvexe und konkave Linsen und andere Linsenformen. Auch Gradientenlinsen und Fresnel-Linsen sind möglich.

Möglich sind auch refraktive Linsen, stückweise refraktive Linsen, Fresnelsche Linsen, diffraktive optische Elemente und/oder refraktiv-diffraktive Hybride.

Die Mikrolinsen, die als einzelne Linsen oder als Mikrolinsenschicht ausgebildet sein können, können Glas, glasartiges Material, Kunststoff, UV-härtbares Polymer und/oder UV-härtbares anorganisch-organisches Hybridpolymer aufweisen oder daraus bestehen. Sie können aus dem gleichen Material wie der Grundkörper oder aus einem anderen Material geformt sein. Insbesondere können sie im optisch transparenten Grundkörper geformt sein, wobei sie vorzugsweise bei der Herstellung des Grundkörpers oder nach dessen Herstellung in diesen eingeformt oder auf diesen abgeformt werden.

Die Ausbildung des Mikrolinsenarrays als Kunststoffformpress- oder Spritzgussteil oder auch als heißgeprägte, dünne Kunststoffplatte, in die auch bereits die Trennwände ("Baffles") eingelassen sein können, ist ebenfalls denkbar.

Offenbart wird außerdem ein Abbildungssystem zur Abbildung eines Objektes in einer Objektfläche in ein Bild in einer Bildfläche. Die Objektfläche ist also jene, vorteilhafterweise ebene, Fläche, in welcher sich ein abzubildendes Objekt befindet, während die Bildfläche jene Fläche ist, in welcher durch die Abbildungsoptik das Bild erzeugt wird. Objekt- und/oder Bildebene sind vorzugsweise parallel zur Ebene, in welcher sich das Mikrolinsenarray oder der Grundkörper oder die Linsenebenen der Mikrolinsen erstreckt. Das Mikrolinsenarray ist zwischen der Bildfläche und der Objektfläche angeordnet. Es ist ein Mikrolinsenarray, wie es oben beschrieben wurde.

Durch das Abbildungssystem kann vorzugsweise ein Objekt, welches in seiner Ausdehnung der Kantenlänge des dem Objekt am nächsten liegenden Mikrolinsenarrays entspricht, in ein Bild in einer Bildebene abgebildet werden, deren laterale Kantenlänge der Kantenlänge jenes Mikrolinsenarrays entspricht, welches der Bildfläche am nächsten liegt.

Für die Anwendungen ist ein Aufbau mit ObjektfeldAnschluss besonders interessant. Ein korrekter Objektfeldanschluss ist Bedingung dafür, dass ein optisches System einen ausgedehnten, insbesondere über das Objektfeld eines einzelnen Kanals ausgedehnten, Objektfeldbereich ohne z.B. mechanisches "scanning" vollständig Abtasten kann.

Das Abbildungssystem kann neben dem ersten Mikrolinsenarray ein weiteres Mikrolinsenarray mit einer Vielzahl von Mikrolinsen aufweisen. Auf diese Weise ist eine Abbildung im herkömmlichen Sinne möglich. Dieses zweite Mikrolinsenarray ist dann so angeordnet, dass jede Mikrolinse des zweiten Mikrolinsenarrays auf der optischen Achse einer Mikrolinse des ersten Mikrolinsenarrays liegt. Vorzugsweise haben die entsprechenden Mikrolinsen des ersten und des zweiten Mikrolinsenarrays parallele Linsenebenen. Außerdem ist es bevorzugt, wenn jeweils die optischen Hauptachsen der beiden Mikrolinsen zusammen fallen. Die Mikrolinsen sind außerdem vorteilhafterweise von gleicher Größe, so dass die Projektion der einen Mikrolinse auf die andere Mikrolinse entlang der optischen Achse die jeweils andere Mikrolinsen genau überdeckt.

Das erste Mikrolinsenarray entwirft hier ein umgekehrtes, reelles Zwischenbild des Objekts. Dieses Zwischenbild wird von einem weiteren Mikrolinsenarray in die Bildebene abgebildet, wobei ein aufrechtes, reelles Bild entsteht. Mindestens ein weiteres Mikrolinsenarray mit Feldlinsen-Funktion kann nahe der Zwischenbildebene eingesetzt werden.

Vorzugsweise bildet das Abbildungssystem das Objekt mit einem Abbildungsmaßstab von m = ri/r0 ab, wobei ri der Krümmungsradius der Bildfläche und r0 der Krümmungsradius der Objektfläche ist.

Außerdem ist bevorzugt, wenn das Bild gegenüber dem Objekt ungedreht, d.h. ohne Drehung, also aufrecht stehend, erzeugbar ist. Darüber hinaus ist es bevorzugt, wenn die Objektfläche keine nicht-abbildbaren Bereiche oder Totzonen aufweist und/oder die Bildfäche keine Bereiche aufweist, die nicht vom Bild abgedeckt werden. Außerdem sollten sich die Bilder einzelner Mikrolinsen vorzugsweise nicht überlappen. Insbesondere kann also jedes System von auf einer gemeinsamen optischen Achse angeordneten Mikrolinsen verschiedener Mikrolinsenarrays einen bestimmten Objektbereich in einen bestimmten Bildbereich abbilden, wobei sich die Objektbereiche und/oder die Bildbereiche unterschiedlicher Mikrolinsensysteme nicht überschneiden, sondern aneinander anschließen und so groß sind, wie der Zentrumsabstand der Mikrolinsensysteme (= Kanäle). Das wird durch die Feldblendengröße in der Zwischenbildebene eingestellt. Alternativ können sich durch benachbarte Kanäle (auch über mehrere benachbarte Kanäle) übertragene Teilbilder aber auch überschneiden, solange sie nur lage- und orientierungsrichtig überlagern. Durch die gleichzeitige Übertragung eines Objektteilbereiches durch mehrere Kanäle in den gleichen Bildteilbereich wird eine Erhöhung der Lichtstärke der abbildenden Optik erreicht.

Die Größe der Bilder der einzelnen Mikrolinsen kann dem Mittelpunktsabstand der Mikrolinsen in ihrer Array-Anordnung entsprechen.

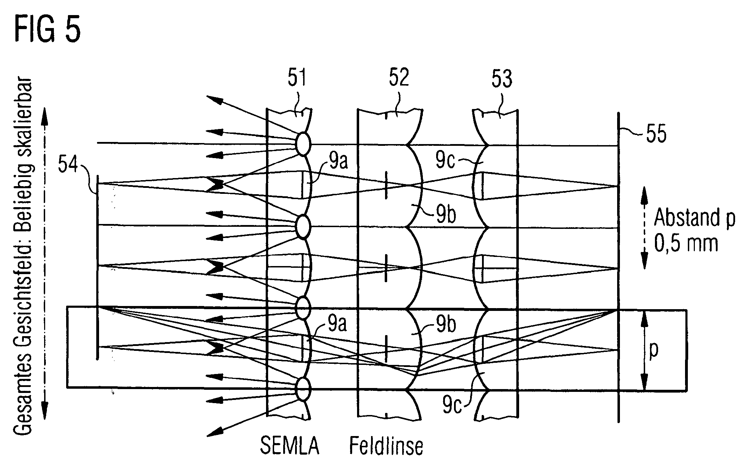

Die Anordnung ist beispielhaft in Figur 5 gezeigt. Die Bilder der einzelnen Mikrolinsen haben hier die Größe p, wobei p gleichzeitig den Mittenabstand der Mikrolinsen beschreibt. Der physische Anschluss der Bilder der einzelnen Mikrolinsen erlaubt in diesem Beispiel die Aufnahme eines lückenlosen Bildes mit einem Bildwandler (oder fotografischen Film) ohne die Notwendigkeit für weitere Bildbearbeitung.

Für viele Anwendungen ist es bevorzugt, wenn der Abbildungsmaßstab des Abbildungssystems m = 1 ist. Das Abbildungssystem bildet also in der Objektebene angeordnete Objekte im Maßstab 1:1 ab.

Mit den Mikrolinsen des ersten Mikrolinsenarrays kann dabei jeweils in einer Zwischenebene ein Zwischenbild von einem Objekt mit einem Abbildungsmaßstab von |m₁|<1 erzeugt werden. Dieses Zwischenbild wird normalerweise gegenüber dem Objekt umgekehrt sein, d.h. um 180° gedreht sein. Mit den Mikrolinsen des zweiten Mikrolinsenarrays kann nun das Zwischenbild mit einem Abbildungsmaßstab 1/m₁ in die Bildebene abgebildet werden. Insgesamt ergibt sich damit ein Abbildungsmaßstab von 1:1.

Sollen durch das Abbildungssystem gekrümmte Objektflächen scharf abgebildet werden, so kann der Abbildungsmaßstab des Abbildungssystems in zumindest einer Richtung parallel zur Fläche des Mikrolinsenarrays variieren. Die Funktion dieser Variation hängt hierbei von der Krümmung der Objektfläche ab.

Es kann weiterhin eine weitere, nach Art einer Feldlinse eingesetzte, optischen Funktionsfläche vorgesehen werden. Es ist bekannt, dass diese für die Abbildungsaufgabe nicht zwingend erforderlich ist, aber unter anderem die Homogenität und Lichtstärke der Abbildung verbessert. Erfindungsgemäß nahe der Zwischenbildebene eingesetzt wird eine Ablenkung der Lichtbündel in die freien Öffnungen der bildseitigen optischen Funktionsflächen bewirkt. Dadurch wird innerhalb der einzelnen Kanäle eine höhere Bildhelligkeit für die, zwar der jeweiligen Achse ferneren, aber noch von der Feldblende durchgelassenen, Objektpunkte erreicht. Allgemein ist also, gemeinsam mit der Feldblenden-Position und Größe, ein gezielter Eingriff in das Vignettierungsverhalten der einzelnen Kanäle möglich. Hierdurch wird eine Vergleichmäßigung (Homogenität) der Bildhelligkeit über mehrere Kanäle des Arrays hinweg erreicht. Diese Homogenisierung ist für eine korrekte Wiedergabe der objekteigenen örtlichen Helligkeitsmodulation sehr wünschenswert und wird mit der vorliegenden Erfindung erzielt.

Neben einem ersten und einem zweiten Mikrolinsenarray weist das Abbildungssystem in diesem Fall also ein weiteres drittes Mikrolinsenarray mit einer Vielzahl von Mikrolinsen auf, welches zwischen dem ersten und dem zweiten Mikrolinsenarray als Teil des entsprechenden Linsensystems so angeordnet ist, dass jeweils eine Mikrolinse des dritten Mikrolinsenarrays auf der optischen Achse einer Mikrolinse des ersten Mikrolinsenarrays liegt. Auch hier fallen vorzugsweise die optischen Achsen der Mikrolinsen dieses dritten Mikrolinsenarrays mit jenen der Mikrolinsen des ersten Mikrolinsenarrays zusammen. Je eine Mikrolinse des ersten, des zweiten und des dritten Mikrolinsenarrays bilden zusammen also einen optischen Kanal, wobei Lichtstrahlen, die in eine Mikrolinse des dem Objekt zugewandten Mikrolinsenarrays einfallen, den dieser Mikrolinse zugeordneten Kanal nicht in einen anderen Kanal verlassen. Auf diese Weise kann unerwünschtes Streulicht minimiert werden.

Vorzugsweise weist das dritte Mikrolinsenarray Strukturen auf, welche in der Bildebene unscharf abgebildet werden.
Zum Beispiel können hier Arrays von diffraktiv wirkenden Fresnel-Zonenplatten besonders vorteilhaft eingesetzt werden. Die Vorteile von insbesondere absorptiv-transmittiv strukturierten Zonenplatten als Feldlinsen liegen in deren einfacher Herstellbarkeit (z.B. als bloßes Strukturierungsdetail der ohnehin erforderlichen absorptiven Blendenschicht). Damit wird der Herstellungsaufwand durch Vermeidung von aufwändigen Prozess-Schritten reduziert. Hinzu tritt als Vorteil eine nur unwesentliche Höhenprofilierung, die es z.B. erlaubt, ein anderes Substrat in berührenden Kontakt mit der Feldlinsenebene zu bringen. Letzteres ist eine Methode um den Systemaufbau, insbesondere die Justage bezüglich Verkippung zwischen den zwei benachbarten Elementen, zu vereinfachen.

Die Abbildung der Struktur der Fresnel-Zonenplatten in die Bildebene ist unerwünscht, da sie der Abbildung der Objektebene bildverschlechternd überlagert wäre. Dies kann verhindert werden, indem die Ebene der Fresnel-Zonenplatten in einem ausreichend großen, aber noch für die übrigen Kriterien genügend kleinen, Abstand zur Zwischenbildebene angeordnet wird. Dadurch kann sichergestellt werden, dass auch die gröbsten Strukturen des diffraktiven Elements noch hinreichend unscharf in die Bildebene abgebildet werden. Als Bedingung hierfür wird gefordert, dass die einem einzelnen Objektpunkt entsprechenden Bündel auf einer Durchtrittsfläche durch das diffraktive Element treten sollen, die mindestens größer ist als die gröbste Struktur des diffraktiven Elements.

Derartige Abbildungskanäle liegen dann vorzugsweise in einem Array vor, das imstande ist, einen seiner senkrechten Projektionsfläche entsprechenden Bereich der Objektebene nahtlos, ohne Lücken, ohne Artefakte und weitestgehend ohne zusätzliche Bildfehler abzubilden (Objektfeldanschluss). Als Vorteilhaft wird ein Objektfeldanschluss mit relativ geringem Überlapp der Einzel-Bildfelder angestrebt, ein Überlapp ist bei besonderer Wichtigkeit hoher Lichtempfindlichkeit aber auch denkbar.

Auch hier ist es bevorzugt, wenn die einzelnen Abbildungssysteme aus je einer Mikrolinse des ersten, des zweiten und des dritten Mikrolinsenarrays disjunkte Bereiche der Objektfläche abbilden, vorzugsweise in disjunkte Bereiche der Bildfläche. Auch hier sollten in der Objektfläche keine Totzonen existieren, die nicht abgebildet werden.

Das Bildfeld jedes Kanals ist weiterhin geeignet zu begrenzen, so dass auch achsfernere Objektpunkte nicht in unerwünschter Weise zur Überlagerung kommen können. Möglich ist diese Begrenzung zum Beispiel durch eine vollständige optische Isolierung der einzelnen Kanäle, z.B. durch absorbierend lichtundurchlässige "vertikale Wände". Auch für die Vermeidung anderer Abbildungsprobleme (Falschlicht, insbesondere Geisterlicht) ist dieses Verfahren günstig. Bedeutend weniger aufwändig ist dieses Ziel jedoch erreichbar, wenn der Abbildungsmaßstab von Objekt nach Zwischenbild kleiner als 1 (m_1 < 1, z.B. m_1 = 0,36, also verkleinernd) gewählt wird. In Verbindung damit wird nahe der Zwischenbildebene ein vorzugsweise planares Feldblendenarray mit einer Vielzahl von Blendenöffnungen eingefügt, das aufgrund seiner planaren Gestaltung günstig herstellbar/integrierbar ist.

Es wird verwendet, um in dessen lichtundurchlässigen Bereichen die überlagerungsgefährdeten Zwischenbilder zu unterdrücken (bevorzugt durch Absorption). Dieser Schutzeffekt wird dann maximal ausgeschöpft, wenn die Feldblendenöffnungen in Form, Größe und gegebenenfalls Absorptionsfaktor gerade so gewählt werden, wie es minimal für eine vollständige, lückenfreie Abbildung der Objektebene erforderlich ist.

Das Feldblendenarray ist so angeordnet, dass jeweils eine Bildebene einer Mikrolinse des ersten Mikrolinsenarrays im Wesentlichen in einer Blendenöffnung des Feldblendenarrays liegt, wobei die Größe der jeweiligen Feldblendenöffnung der Größe des jeweiligen Zwischenbildes entspricht bzw. gar diese definiert. Es ist bevorzugt, dass die axiale Position des Feldblendenarrays zur Zwischenbildebene und/oder die Form der Blendenöffnungen derart gestaltet sind, dass die Helligkeit eines Bildpunktes unabhängig ist von der lateralen Entfernung zwischen dem Bildpunkt und den optischen Achsen der zu dessen Bild beitragenden benachbarten Mikrolinsenkanäle.

Der Aufbau ist beispielhaft in Figur 5 dargestellt. Im unteren Kanal in Figur 5 sieht man, wie ein Objektpunkt von Fläche 54 am oberen Rand dieses Kanals in den unteren Rand der Feldblendenebene in der Mitte des Elementes 52 abgebildet wird. D.h. die Größe der Feldblende entspricht hier der Größe des jeweiligen Zwischenbildes. Die Homogenität der Lichtverteilung im Bild (eines Kanals) kann hierbei durch die axiale Position der Feldblende relativ zu der des Zwischenbildes sowie durch die Form der Feldblende beeinflusst werden. Beide Möglichkeiten werden genutzt, um eine möglichst hohe Homogenität des Bildes eines Kanals und somit auch des Gesamtbildes zu erreichen. Letzteres beschreibt, dass die Helligkeit eines Bildpunktes unabhängig von der lateralen Entfernung zwischen Bildpunkt und optischer Achse eines Kanals ist.

Die Kanalstruktur des Abbildungsystems soll sich nicht in eine (zusätzliche und ungewünschte) Modulation (also von der Objektmodulation abweichenden Modulation) des Gesamtbildes durchprägen. Falls dieses sich aber nicht vermeiden lässt, kann es auch durch nachträgliche digitale Bildverarbeitung (Kalibration) kompensiert werden, wie auch der Bildanschluss (nicht aber Objektfeldanschluss) dadurch erreicht werden kann.

Auch nahe den objektseitigen sowie bildseitigen optischen Funktionsflächen können optionale Blendenschichten angeordnet werden. Einerseits dienen diese der Abdeckung von Randbereichen einzelner Linsen und von Übergangsbereichen zwischen benachbarten Linsen. Die in diesen Flächenbereichen durchgehenden Strahlen sind den Abbildungseigenschaften abträglich und werden daher vorteilhafterweise ausgeblendet.

Weiterhin werden durch eine größere Anzahl von Blendenschichten mit möglichst großem axialen Abstand zueinander sowie möglichst kleinen Öffnungsanteilen (geringen Füllfaktoren) die effektiven Querschnitte für störende Strahlengänge (sog. Geister-Strahlen, die schräg durch Elemente mehrerer Abbildungskanäle verlaufen) reduziert.

Zur Minimierung von Streulicht können zwischen zumindest zwei oder allen zueinander benachbarten Mikrolinsen eines Mikrolinsenarrays, Linsensystems und/oder zwischen benachbarten Lichtquelle auch absorbierende und/oder lichtundurchlässige Wände angeordnet sein. Die Wände können sich insbesondere über den Abstand zwischen zwei benachbarten Mikrolinsenarrays erstrecken, so dass die Abbildungskanäle gegeneinander durch derartige lichtundurchlässige Wände abgeschirmt sind. Auch der Grundkörper kann bei entsprechender Materialwahl so strukturiert sein.

Eine besonders robuste und gut zu justierende Herstellung des Abbildungssystems ist möglich, wenn das erste und/oder das zweite und/oder das dritte Mikrolinsenarray und/oder ein eventuell vorhandenes Feldblendenarray formschlüssig mit ihren Flächen aneinander angeordnet sind.

Das erfindungsgemäße Abbildungssystem kann außerdem zusätzliche Blendschichten mit großem axialen Abstand voneinander und kleinen Blendenöffnungen aufweisen.

Die gewünschte Abbildungsfunktion kann mit drei einseitig strukturierten Grundkörpern erzielt werden. Es kann aber auch zumindest eines der Mikrolinsenarrays eine Kombination aus zumindest zwei Mikrolinsenarrays sein. Darüber hinaus kann in oder nahe der Bildebene bzw. Bildfläche ein Array von Zerstreuungslinsen angeordnet sein.

Das Abbildungssystem ist vorzugsweise so ausgestaltet, dass Störlicht, welches durch Reflexe und/oder unter großem Winkel zur optischen Achse der Mikrolinsen auf die Bildfläche einfällt, auf seinem Weg eine stark abschwächende Vignettierung durch Blendenebenen, mit geringem Öffnungsdurchmesser im Vergleich zum Mittenabstand der Öffnungen, erfährt.

Ein oder mehrere Mikrolinsenarrays können eine Oberflächenbeschichtung aufweisen, welche deren optische Eigenschaften verbessert.

Es wird außerdem ein Abbildungsverfahren zur Abbildung zumindest eines Objektes in einer Objektfläche in ein Bild in einer Bildfläche zur Verfügung gestellt, wobei die Abbildung durch ein oben beschriebenes Abbildungssystem bewirkt wird.

Erfindungsgemäß wird außerdem ein Verfahren zur Herstellung eines Mikrolinsenarrays, wie es oben beschrieben wurde, bereitgestellt. Hierbei wird eine Vielzahl von Mikrolinsen, vorzugsweise in einer Array-Anordnung, auf, in an und/oder hinter einer ersten Seite eines flächigen, optisch transparenten Grundkörpers angeordnet oder geformt. An, in oder auf dem optischen transparenten Grundkörper wird außerdem zumindest eine Lichtquelle so angeordnet, dass die Projektion der zumindest einen Lichtquelle in Richtung der optischen Hauptachsen der Mikrolinsen oder in einer Richtung senkrecht zur Ebene des Mikrolinsenarrays auf die erste Seite zwischen den Linsen liegt. Für die hier hergestellten Komponenten gilt das oben gesagte.

Zumindest eine Elektrode in Kontakt mit zumindest einem Teil oder allen Lichtquellen wird vorzugsweise durch Aufdampfen zumindest eines metallischen Materials hergestellt. Beim Aufdampfen kann eine Schattenmaske zur Strukturierung der Elektroden verwendet werden.

Die Mikrolinsen können durch Reflow-Prozesse, Abformung von UV-härtendem Polymer, UV-Reaktionsguss, Ätzen in Glas, Prägen, Drucken, in einem Kunststoff-Formpress-Prozess, durch Spritzguss und/oder durch eine Abformtechnik mit Negativformen hergestellt werden.

Besonders vorteilhaft sind Abformtechniken, bei denen eine vorher fließfähige Grundsubstanz in Kontakt mit einer Negativform ausgehärtet wird. Bei diesen Verfahren sind thermische, mechanische und chemische Prozessparameter erreichbar, die mit den Haltbarkeits-Grenzen von (in Material und Aufbau) geeigneten OLEDs kompatibel sind..Es lassen sich dadurch Mikrolinsen auf zuvor hergestellte OLEDs aufbringen. Zusätzliche Vorteile können realisiert werden, wenn das ausgehärtete Mikrolinsen-Material in Form einer durchgehenden Schicht eine Kapselung der empfindlichen OLEDs gegenüber Umgebungseinflüssen, wie z.B. Wasser, Sauerstoff, mechanischem Druck, etc., erbringt. Die oben beschriebene Abschirmung bildwärts abgestrahlten Lichts der Beleuchtungselemente kann diese OLED-Bereiche bei UV-Aushärtungsschritten vor UV-Licht schützen.

Offenbart ist außerdem eine Bilderfassungsvorrichtung mit einem wie oben beschriebenen erfindungsgemäßen Abbildungssystem. Hierbei ist in oder nahe der Bildfläche oder Bildebene zumindest ein optoelektronischer Bildwandler oder photographischer Film angeordnet. Der Bildwandler kann ein digitaler Bildwandler, ein CCD-Chip, ein CMOS- und/oder ein organischer Bildsensor sein. Vorzugsweise wird die Bilderfassungsvorrichtung so eingerichtet, dass die Größe der Detektorpixel eines Bildwandlers oder eines digitalen Bildwandlers oder eines CCD-Chips oder eines CMOS- oder organischen Bildsensors der Größe der kleinsten vom System noch auflösbaren Objektfeatures entspricht, oder dass die Auflösung eines photographischen Filmes gerade der vom System noch auflösbaren Größe von Teilen des Objektes entspricht. Außerdem kann die laterale Ausdehnung des Bildsensors der lateralen Ausdehnung des Objektes und/oder der Mikrolinsenanordnung entsprechen.

Das Optik-Design ist problemlos skalierbar. Werden alle linearen Abmessungen, inkl. Krümmungsradien, Aperturgrößen, etc. (mit Ausnahme der Wellenlänge), beispielsweise zum Kleineren hin skaliert, so reduziert sich zwar das jeweilige Objektfeld jedes einzelnen Abbildungskanals. Das zusammengesetzt abbildbare Objektfeld kann in seiner lateralen Ausdehnung jedoch erhalten werden, indem lediglich eine größere Anzahl der nunmehr kleineren Abbildungskanäle zu der Array-Optik zusammengesetzt wird. Dies wird durch die erfindungsgemäß realisierten Eigenschaften der Anreihbarkeit (Feldanschluss-Bedingungen) ermöglicht, die bei Skalierung erhalten bleiben.

Im Folgenden soll die Erfindung anhand einiger Beispiele erläutert werden. Diese Beispiele sind nicht beschränkend zu verstehen und die in ihnen gezeigten Merkmale können erfindungsgemäß auch untereinander kombiniert werden.

### Es zeigt

Figur 1 einen Schnitt durch ein erfindungsgemäßes Mikrolinsenarray,
Figur 2 eine schematische Darstellung der Schichten in einem erfindungsgemäßen Mikrolinsenarray,
Figur 3 eine schematische Darstellung der Flächenaufteilung in einem erfindungsgemäßen Mikrolinsenarray,
Figur 4 eine Aufsicht auf ein erfindungsgemäßes Mikrolinsenarray,
Figur 5 einen Schnitt durch ein Abbildungssystem und
Figur 6 eine Tabelle mit beispielhaften Zahlenwerten für die Gestaltung des erfindungsgemäßen Mikrolinsenarrays.

### Ausführungsbeispiel 1

### Schichtfolge und -aufbau

Figur 1 stellt in schematischen Größenverhältnissen ein Beispiel für einen möglichen Aufbau eines erfindungsgemäßen Mikrolinsenarrays dar.

Auf einem Glassubstrat 1 befindet sich eine elektrisch leitfähige, transparente Schicht 2 aus beispielsweise 10 bis 500 nm oder 100 bis 200 nm Indium-Zinn-Oxid (ITO). Für dieses Ausführungsbeispiel wird eine ITO-Schicht beispielsweise von 180 nm oder 145 nm Dicke verwendet, die in Form ITO-beschichteter Glassubstrate am Markt erhältlich ist.

Die ITO-Schicht 2 (Anode) wird mittels üblicher Ätzprozesse vorteilhaft grob strukturiert.

Darauf wird eine Schicht 3 aus elektrisch nichtleitendem, stark absorbierendem Polymer, beispielsweise einem "Black-Polymer" wie PSK1000 (BrewerScience), photolithographisch strukturiert. Diese Schicht enthält Justiermarken 702 für die folgenden Schichten. Aus Gründen der Sichtbarkeit und der Vermeidung von Fehler-Akkumulation werden die Schichten vorteilhaft alle auf diese Schicht 3 hin justieren.

Die Schicht 3 enthält funktional transparente, also freigelassene, Öffnungen für die optischen Abbildungskanäle 4 und transparente, freigelassene Öffnungen für die Beleuchtungselemente 5.

In die Öffnungen für die Beleuchtungselemente 5 werden in diesem Ausführungsbeispiel lichtemittierende organische Materialien 6 für organische Leuchtdioden (OLEDs) eingebracht. Vorteilhaft geschieht dies mittels eines Aufdampfverfahrens durch eine mit moderaten Genauigkeitsanforderungen justierte Schattenmaske.

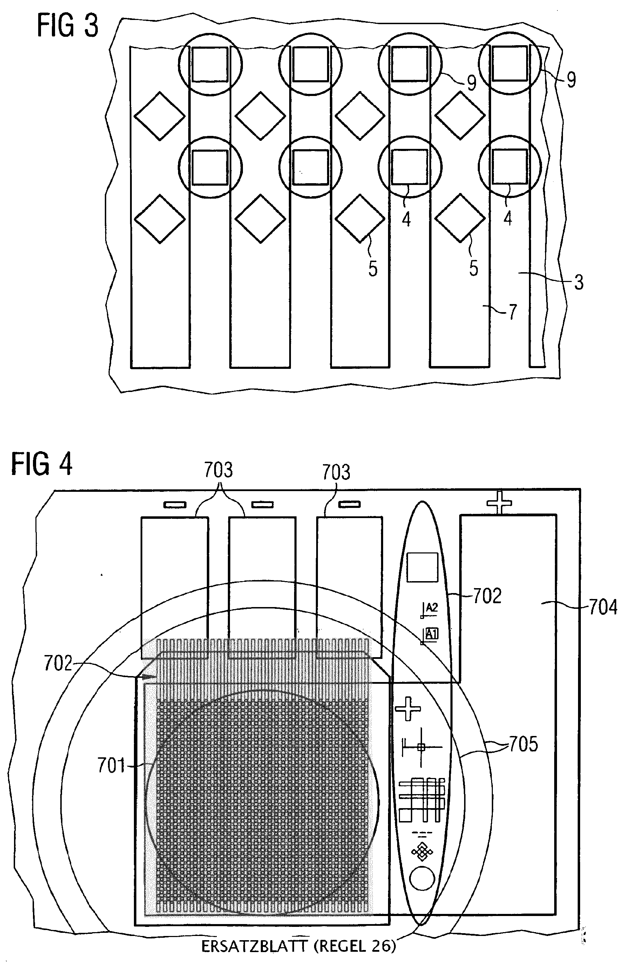

Als Kathoden sind geeignete Metallschichten 7 so aufgebracht, dass die Öffnungen für die Beleuchtungselemente 5 vollständig, die Öffnungen für die optischen Abbildungskanäle 4 jedoch nicht bedeckt werden (siehe Figur 3). Dies kann wiederum beispielsweise durch Aufdampfprozesse mit Schattenmasken erfolgen, wobei der Aufbau mit einer nicht-leitenden Schicht 3 insbesondere erlaubt, für die Schichten 6 und 7 dieselbe Schattenmaske, gegebenenfalls sogar ohne Maskenwechsel zu verwenden. Die Schattenmasken sind dabei so gestaltet, dass die Metallschichten 7 durchgehende Streifen bis in Randzonen des Gesamtelements bilden, wo sie extern elektrisch kontaktiert werden und so die Stromzuführung zu den OLED-Kathoden realisieren.

Geeignete Materialien für die Metallschichten 7 sind Aluminium oder Metalle mit geringerer Austrittsarbeit oder Kombinationen hiervon. Durch deren sehr geringe Transparenz wird außerdem eine Abstrahlung der Lichtquellen in Richtung der Bildseite verhindert.

Zuletzt wird in dieser Ausführungsvariante eine Schicht 8 aus einem transparent aushärtenden, zur UV-Abformung von Optiken geeigneten Polymer, insbesondere anorganisch-organischen Hybridpolymers, wie beispielsweise ORMOCER^{®}, aufgebracht. Durch UV-Abformung, bevorzugt in einem Mask-Aligner, werden über den Öffnungen für die Abbildungskanäle 4 Mikrolinsen 9 erzeugt.

Die Schichterzeugung der Schicht 8 wird unter Randbedingungen durchgeführt, die eine Beeinträchtigung der bestehenden Beleuchtungselemente 6, beispielsweise OLEDs, verhindern. Dies wird durch Aufbringen des UVabformbaren Polymers unter Stickstoff-Atmosphäre und ausschließlicher Verwendung von chemisch mit OLEDs verträglichen Materialien erreicht.

Figur 2 stellt schematisch dar, wie die Schichten ohne Darstellung Ihrer Strukturierung in Ihren Überlappungen vorteilhaft angeordnet werden können. Ein UVabformbares Polymer 8, wie z.B. ORMOCER, kann über der OLED 6 aufgebracht werden und zumindest teilweise die Funktion einer Primärverkapselung gegen schädliche Umgebungseinflüsse, wie z.B. Wasserdampf, Sauerstoff, mechanische Einflüsse, etc., erfüllen.

Das dargestellte Ausführungsbeispiel ist daraufhin so ausgelegt, dass nur ein Schichttyp 2, beispielsweise ITO, die Grenzen der ORMOCER-Bedeckung zur Seite hin schneidet und die elektrische Kontaktierung nach außen bildet.

Figur 2 zeigt eine Schichtreihen- oder eine Technologieschrittfolge, ohne dabei auf die Struktur der Schichten einzugehen. Einzig Randdurchbrüche der verschiedenen Schichten durch andere sind mit gezeigt. Die Struktur der einzelnen Schichten wird in Figur 1 beschrieben. Dort ist auch der Kontakt zwischen ITO und OLED gezeigt, der natürlich hergestellt werden muss, um die OLED elektrisch anzusteuern, also den Stromfluss zu ermöglichen.

Figur 3 stellt dar, wie in einem erfindungsgemäßen Mikrolinsenarray die Aufteilung der Substratgrundfläche beispielhaft günstig realisiert ist.

In einer ansonsten lichtundurchlässigen Schicht 3, die hier aus PSK1000 BlackMatrix-Polymer (Brewer-Science) hergestellt ist, sind zwei Arten von transparenten Öffnungen strukturiert.

Die transparenten Öffnungen für die Abbildungskanäle 4 sind quadratisch, 180 µm x 180 µm groß und mit periodischer Wiederholung nach jeweils 500 µm in zwei zueinander senkrechten Richtungen in der Substratebene angeordnet. Zwischen diesen Öffnungen 4 liegen die lichtemittierenden Zonen der Beleuchtungselemente 5, die ebenfalls durch Öffnungen in der elektrisch nicht-leitenden BlackMatrix-Schicht 3 definiert werden. Die Beleuchtungselemente 5 sind hier beispielsweise 180 µm x 180 µm groß und sind in einem Raster analog zu dem der Öffnungen 4 in dessen Zwischenräumen angeordnet.

Die Ausrichtung der Quadrate 5 gegenüber den Öffnungen für die Abbildungskanäle 4 ist um 45° gedreht, um den Minimalabstand zwischen den beiden Funktionsflächen 4, 5 zu vergrößern. Letzteres dient in Verbindung mit ausreichend dünn gewählten Substraten 1 zur Störlichtreduktion in einem mit Mikrolinsenarrays aufgebauten Abbildungssystem. Die Öffnungen der Abbildungskanäle 4 werden so nur von einfach reflektierten Strahlen mit einem möglichst großen minimalen Winkel zur Flächennormalen getroffen.

Zwischen den Öffnungen der Abbildungskanäle 4 verlaufen ca. 300 µm-Streifen des metallischen Kathodenmaterials 7, beispielsweise Aluminium, die den Beleuchtungselementen 5 als Elektroden und Stromzuführung dienen. Die Streifen 7 werden beispielsweise aufgedampft, wobei die Strukturierung mittels einer justierten Schattenmaske aus 180 µm starkem Edelstahl erzielt wird. Die Kathoden werden über Strukturierung von den eigentlichen Anodenbereichen getrennte ITO-Bahnen elektrisch nach außen kontaktiert.

Beispielhaft sind die Grundflächen für die abgeformten Mikrolinsen 9 eingetragen, die nicht notwendigerweise die Form von Kreisscheiben haben müssen. Die Mindestgröße dieser Grundflächen 9 bestimmt sich nach dem Durchtrittsquerschnitt der erwünschten, von den Blendenschichten begrenzten, Strahlenbündel in der Ebene des Linsenscheitels. Diese Größen sind mithilfe der angegebenen "Prescription Data" und z.B. gängiger Optikdesign-Software direkt erhältlich. Bei drei Mikrolinsenarrays sind die Grundflächen der Linsen 9 der äußeren Mikrolinsenarrays beispielhaft mit einem Durchmesser von 300 µm gewählt. Das dazwischen liegende Mikrolinsenarray hat Mikrolinsen 9 mit einem Durchmesser von 400 µm (aufgrund eines größeren Abstands zwischen Linsenscheitel und Blendenebene)

Figur 4 zeigt eine Draufsicht auf ein erfindungsgemäßes Mikrolinsenarray. Die aktive Zone 701 ist ca. 16 mm x 16 mm groß und enthält darauf 31 x 31 Abbildungselemente 9 (Mikrolinsen 9) sowie 32 x 32 Beleuchtungselemente 5 (OLED-Pixel 6). Ein streifenförmiger Bereich 702 enthält bequem auffindbar verschiedene Alignment-Markierungen zur Justage und Strukturen zur Prozess-Diagnose. Die Kontaktierungsbereiche für die externe Stromzufuhr zu den OLEDs bilden die ITO-Flächen 703 (drei Kathodenbereiche) und 704 (gemeinsamer Anodenbereich). Die Hilfslinien 705 umschließen diejenige Kreisscheibe, die minimal (innerer Kreis) bzw. maximal (äußerer Kreis) von dem verkapselnden Linsenmaterial 8, z.B. einem ORMOCER^{®}, bedeckt werden soll.

Figur 5 zeigt schematisch einen Teil eines Schnittes durch ein erfindungsgemäßes flaches 1:1-Abbildungssystem, das hier ein erfindungsgemäßes Mikrolinsenarray 51 als vorderstes Element einsetzt. Das Array-Abbildungssystem entsteht durch lateral beliebig ausgedehnte flächige Aneinanderreihung von einkanaligen Abbildungssystemen. Ohne weiteres Optikdesign und ohne Einfluss auf den Objekt-Bild-Abstand kann das Objektfeld 54 des Array-Abbildungssystems an die abzubildende Objektfläche 54 angepasst werden. Alternativ kann das Bildfeld des Array-Abbildungssystems in Fläche und Formgebung an einen gegebenen Bildsensor (CCD, CMOS, OPD, ein Bildsensor basierend auf einem organischen Halbleitermaterial als aktive Schicht, u.ä.) angepasst werden.

Das beispielhafte Abbildungssystem bildet eine Objektebene 54 mit Objektfeldanschluss und Bildfeldanschluss auf die Bildfläche 55 ab.

Es ist durch drei refraktive Mikrolinsenarrays (MLA) 51, 52, 53 auf Glassubstraten realisiert. In dieser Ausführungsvariante ist das objektseitig erste MLA 51 ein erfindungsgemäßes Mikrolinsenarray 51, welches wie in obigem Ausführungsbeispiel angegeben, beschaffen sein kann.

Auch das zweite Mikrolinsenarray 52 und das dritte Mikrolinsenarray 53 ist herstellungstechnisch günstig jeweils durch einseitige Beschichtung eines Glassubstrates 1 hergestellt. Sie enthalten eine Blendschicht aus stark absorbierendem Polymer, wie z.B. PSK2000, das in diesem Fall keinen besonderen elektrischen Anforderungen genügen muss. Die Mikrolinsen 9a, 9b, 9c sind aus einem transparent aushärtenden, zur UV-Abformung von Optiken geeigneten Polymer 8, wie z.B. ORMOCER^{®}, hergestellt. Durch UV-Abformung, bevorzugt in einem Mask-Aligner, werden über den Öffnungen für die Abbildungskanäle 4 dazu justierte Mikrolinsen 9a, 9b, 9c erzeugt.

Das angegebene Optikdesign ist so angelegt, dass die Blendenschichtöffnungen für die Abbildungskanäle 4 in allen drei Arrays 51, 52, 53 identisch sind. Dies ermöglicht die Verwendung derselben photolithographische Maske(n) für mehrere Blendschichten im System und ist dadurch insbesondere für kleine Serien und Prototypen eine ökonomische Variante. Diese Randbedingung kann zugunsten verbesserter Abbildungseigenschaften fallengelassen werden, wenn der ökonomische Vorteil der Maskenersparnis nicht ins Gewicht fällt.

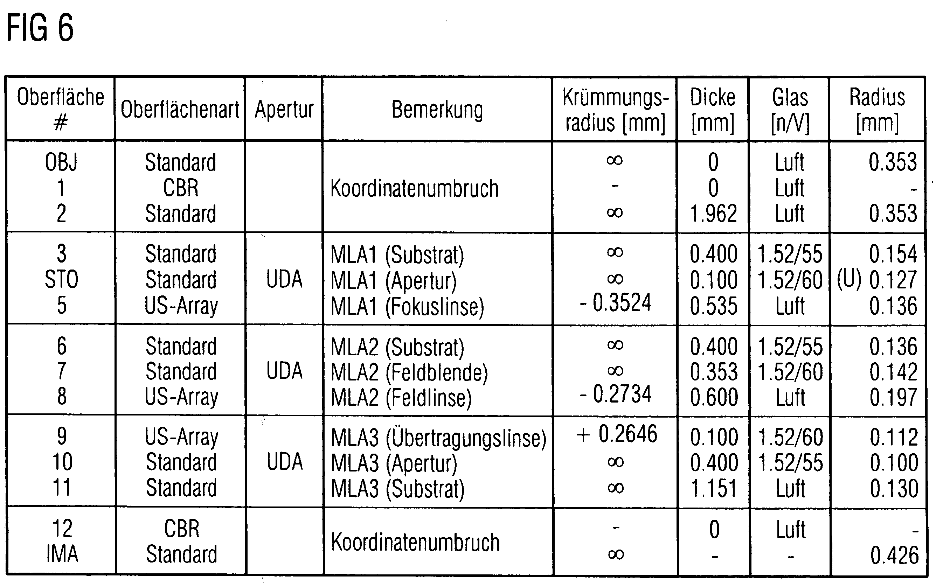

Die Tabelle in Figur 6 beschreibt den optischen Schichtaufbau eines Abbildungssystems mit dem Abbildungsmaßstab 1:1. Jede Zeile entspricht einer Schicht. Bis auf das Objekt (OBJ), das Bild (IMA) und den Apertur Stop (STO) sind alle Flächen mit laufenden Nummern bezeichnet. Die Spalten beinhalten wichtige Parameter jeder Fläche (von links nach rechts: Flächennummer, Flächentyp, Apertur, Kommentar, Krümmungsradius (RoC für Radius of Curvature), Dicke, Glasart (beschrieben durch zwei Parameter n und V), lateraler Radius (Semi-Diameter)). Flächen mit einem unendlich großen Krümmungsradius sind planparallel.

Die optischen Daten der Beispiele sind in Figur 6 wiedergegeben. Das Array setzt sich aus identischen Kopien von Einzelkanälen mit den dort beschriebenen Eigenschaften zusammen, deren optische Achsen parallel zueinander orientiert sind. Die Kanäle sind in einem kartesischen Raster angeordnet, dessen Länge periodischer Wiederholung in beiden Richtungen 500 µm beträgt. Alle Einzelkanäle sind auf einer gemeinsamen, ebenen Anordnungsfläche angeordnet.

Auf den Flächen 4, 7 und 10 befinden sich in jedem Abbildungskanal jeweils eine quadratische Blendenöffnung mit einem transparenten Bereich von 180 µm x 180 µm.

Die hier bezeichneten Flächen sind in der Tabelle in Figur 6 aufgelistet. Sie sind durch die Bezeichnung "UDA" für "User Defined Aperture" in der Spalte "Aperture" gekennzeichnet.

Es resultiert ein System mit einem Objekt-Bild-Abstand von 6 mm. Zur 1:1-Abbildung des 15,5 mm x 15,5 mm großen Objektfeldes werden 31 x 31 optische Abbildungskanäle sowie 32 x 32 Beleuchtungselemente (OLEDs) eingesetzt.

### 2. Ausführungsbeispiel

Gemäß dieser Feststellung soll nun ein 2. Ausführungsbeispiel auf Basis des vorhergehenden Beispiels angegeben werden. Um unnötige Wiederholungen zu vermeiden soll dies wie folgt gefasst werden:
Dieses Ausführungsbeispiel entspricht dem Aufbau nach des 1. Ausführungsbeispiels. Alle linearen Abmessungen, die in den optischen Daten der Figur 6 enthalten sind, sollen mit dem Faktor 0,1 multipliziert (skaliert) werden und ergeben danach die optischen Daten dieses 2. Ausführungsbeispiels. Insbesondere sind dies die Daten der Spalten RoC (Radius of Curvature, Krümmungsradius), "Thickness" (axiale Flächen-Abstände) sowie "der Form halber" "Semi-Diameter" (Radius der Durchtrittsfläche). Es ist zu beachten, dass die notwendigen Substratdicken ebenfalls skaliert werden müssen. Es kann im Einzelfall sinnvoll sein und ist erfindungsgemäß ohne weiteres möglich, den Skalierungsfaktor so anzupassen, dass sich nach der Skalierung marktgängige Zukaufteile, z.B. Substratgläser in Standard-Dicken, verwenden lassen.

Gleichzeitig sollen die linearen Abmessungen bezüglich der Draufsichten auf die Mikrolinsenarrays mit dem Faktor 0,1 multipliziert werden. Es ergibt sich daraus ein Pitch (Wiederholungsperiode) von 50 µm, jeweils Blendenöffnungen von 18 µm x 18 µm, OLED-Pixel von 18 µm x 18 µm und Kathodenstreifenbreiten von 30 µm.

Nach dieser Skalierung resultiert ein System mit einem Objekt-Bild-Abstand von 600 µm. Zur 1:1-Abbildung des 15,5 mm x 15,5 mm großen Objektfeldes werden 310 x 310 optische Abbildungskanäle sowie 311 x 311 Beleuchtungselemente (OLEDs) eingesetzt.

## Patentansprüche

1. Mikrolinsenarray zur Abbildung eines flächig ausgedehnten Objektes mit einem flächigen, optisch transparenten Grundkörper (8) in eine Bildebene, der sich in einer Ebene erstreckt, einer Vielzahl von auf, an oder in einer ersten Seite des optisch transparenten Grundkörpers angeordneten Mikrolinsen (9), die voneinander beabstandet sind und zu der Ebene parallele Linsenebenen haben und einer Vielzahl von Lichtquellen (6), welche an jener der ersten Seite gegenüberliegenden Seite des optisch transparenten Grundkörpers (8) angeordnet sind, wobei die Projektionen der Lichtquellen (6) in Richtung der optischen Achsen der Mikrolinsen (9) auf die erste Seite des optisch transparenten Grundkörpers (8) zwischen den Mikrolinsen (9) liegen und wobei eine Haupt-Lichtabstrahlrichtung der Lichtquellen parallel zu den optischen Achsen der Mikrolinsen (9) in Richtung des abzubildenden Objekts liegen wobei das Mikrolinsenarray zwischen der Bildebene und der Objektfläche angeordnet ist.

2. Mikrolinsenarray nach dem vorhergehenden Anspruch, **dadurch gekennzeichnet, dass** mindestens eine Lichtquelle (6) eine flächige Lichtquelle, eine organische Leuchtdiode, eine organische Lumineszensdiode, strukturierte EL-Folie oder Quantum-Dot-LEDs aufweist.

3. Mikrolinsenarray nach einem der vorhergehenden Ansprüche, **dadurch gekennzeichnet, dass** das Verhältnis von axialer Kantenlänge des Verbunds von Mikrolinsenarray und optisch transparentem Grundkörper (8) zur lateralen Kantenlänge kleiner als 1:3, bevorzugt kleiner als 1:25, oder kleiner als 1:1000 ist.

4. Mikrolinsenarray nach einem der vorhergehenden Ansprüche, **dadurch gekennzeichnet, dass** die zumindest eine Lichtquelle (6) flächig ausgeprägt ist aber nur in array-artig angeordneten Zonen Licht-emittierend wirkt.

5. Mikrolinsenarray nach einem der vorhergehenden Ansprüche, **dadurch gekennzeichnet, dass** das Mikrolinsenarray zumindest eine Lichtquelle (6) aufweist und dass zumindest eine der Lichtquellen von einer Blendenschicht (3) in einer Ebene parallel zur Ebene ihrer Lichtaustrittsfläche umgeben ist, die ausgenommen vom objektseitigen Raumwinkelbereich und in der Projektionsrichtung der Mikrolinsen (9) entlang ihrer optischen Achsen lichtundurchlässig ist, oder dass das Mikrolinsenarray zumindest zwei Lichtquellen (6) aufweist und dass zumindest zwei der zumindest zwei Lichtquellen von einer sich zwischen ihnen erstreckenden Blendenschicht (3) in einer Ebene parallel zur Ebene ihrer Anordnung umgeben sind, die ausgenommen vom objektseitigen Raumwinkelbereich und in der Projektionsrichtung der Mikrolinsen (9) entlang ihrer optischen Achsen lichtundurchlässig ist.

6. Mikrolinsenarray nach dem vorhergehenden Anspruch, **dadurch gekennzeichnet, dass** die Blendenschicht (3) elektrisch nicht-leitende, strukturierbare Materialien oder zumindest ein Black-Matrix-Polymer mit einem hohen Volumenwiderstand aufweist oder daraus besteht.

7. Mikrolinsenarray nach einem der vorhergehenden Ansprüche, **dadurch gekennzeichnet, dass** die zumindest eine Lichtquelle (9) durch zumindest eine Anode (2) und zumindest eine Kathode (7) als Elektroden kontaktiert wird, wobei die zumindest eine Anode (2) oder die zumindest eine Kathode (7) lichtundurchlässig ist und so angeordnet ist, dass die entsprechende Lichtquelle (9) durch die Anode (2) oder die Kathode (7) in eine Richtung entlang der Achse der Mikrolinsen (9) lichtundurchlässig abgeschirmt ist.

8. Mikrolinsenarray nach einem der vorhergehenden Ansprüche, **dadurch gekennzeichnet, dass** zwischen dem optisch transparenten Grundkörper (8) und der zumindest einen Lichtquelle (9) eine lichtdurchlässige Elektrode aus elektrisch leitfähigem Material angeordnet ist oder auf der gegenüberliegenden Seite der Lichtquelle eine lichtundurchlässige Elektrode aus elektrisch-leitfähigem Material angeordnet ist.

9. Mikrolinsenarray nach einem der vorhergehenden Ansprüche, **dadurch gekennzeichnet, dass** bildseitig die Anode oder Kathode (7) zumindest einer Lichtquelle gleichzeitig als lichtundurchlässige Blendenschicht dient, um Lichtabstrahlung in Richtung der Bildseite zu verhindern.

10. Mikrolinsenarray nach einem der vorhergehenden Ansprüche, **gekennzeichnet durch** eine auf der den Mikrolinsen abgewandten oder der die Mikrolinsen aufweisenden Seite des Mikrolinsenarrays angeordnete leitfähige, transparente Schicht (2), welche Indium-Zinn-Oxid (ITO), ZnO oder dünne Metallschichten aufweist oder daraus besteht.

11. Mikrolinsenarray nach einem der vorhergehenden Ansprüche, **gekennzeichnet durch** mindestens eine lichtundurchlässige Elektrode (2) oder mindestens eine Licht-absorbierende Blendenschicht (3), die so angeordnet ist, dass sowohl die Lichtabstrahlung der Lichtquelle als auch die Reflexion des von den Lichtquellen (6) emittierten Lichtes von allen Elementen außer dem abzubildenden Objekt in Richtung der Bildseite verhindert wird.

12. Mikrolinsenarray nach einem der vorhergehenden Ansprüche, **dadurch gekennzeichnet, dass** der optisch transparente Grundkörper (8) derart dünn ausgeführt ist, dass das von den Lichtquellen (6) emittierte Licht bei einmaliger Totalreflexion an der objektseitigen Grenzfläche des optisch transparenten Grundkörpers (8) nicht in eine benachbarte Mikrolinse (9) einfallen kann.

13. Verfahren zur Herstellung eines Mikrolinsenarrays nach einem der Ansprüche 1 bis 12, wobei eine Vielzahl von Mikrolinsen in einer Array-Anordnung auf, an, in und/oder hinter einer ersten Seite eines flächigen, optisch transparenten Grundkörpers angeordnet oder geformt wird und zumindest eine Lichtquelle so an, in oder auf dem optisch transparenten Grundkörper angeordnet wird, dass die Projektion der zumindest einen Lichtquelle in Richtung der optischen Hauptachsen der Mikrolinsen auf die erste Seite zwischen den Linsen liegt.

## Claims

1. Microlens array for imaging a two-dimensionally extending object in an image plane with a flat, optically transparent basic body (8) extending in a plane, a plurality of microlenses (9) disposed on, at or in a first side of the optically transparent basic body, which are at a distance from each other, which microlenses have lense planes parallel to said plane, and a plurality of light sources (6) which are disposed at that side of the optically transparent basic body (8) which is opposite to the first side, the projections of the light sources (6) being in the direction of the optical axes of the microlenses (9) onto the first side of the optically transparent basic body (8) between the microlenses (9), and wherein a main light emission direction of the light sources is parallel to the optical axes of the microlenses (9) in the direction of the object to be imaged, the microlens array being arranged between the image plane and the object plane.

2. Microlens array according to the preceding claim, **characterised in that** at least one light source (6) has a flat light source, an organic light diode, an organic luminescent diode, structured EL foil or quantum dot LEDs.

3. Microlens array according to one of the preceding claims, **characterised in that** the ratio of axial edge length of the composite of microlens array and optically transparent basic body (8) to the lateral edge length is less than 1 : 3, preferably less than 1 : 25, particularly preferred less than 1 : 1000.

4. Microlens array according to one of the preceding claims, **characterised in that** the at least one light source (6) is shaped flat but has a light-emitting effect only in zones disposed in an array-like manner.

5. Microlens array according to one of the preceding claims, **characterised in that** the microlens array has at least one light source (6) and **in that** at least one of the light sources is surrounded by an aperture layer (3) in a plane parallel to the plane of its light outlet surface which, apart from the object-side solid angle region and in the projection direction of the microlenses (9), is light-impermeable along its optical axes, or that the microlens array has at least two light sources (6) and **in that** at least two of the at least two light sources are surrounded by an aperture layer (3) which extends between them in a plane parallel to the plane of its arrangement, which, apart from the object-side solid angle region and in the projection direction of the microlenses (9), is light-impermeable along its optical axes.

6. Microlens array according to the preceding claim, **characterised in that** the aperture layer (3) comprises or consists of electrically non-conducting, structurable and/or light-absorbing materials, or at least one black matrix polymer with a high volume resistance.

7. Microlens array according to one of the preceding claims, **characterised in that** the at least one light source (9) is contacted by at least one anode (2) and at least one cathode (7) as electrodes, wherein the at least one anode (2) or the at least one cathode (7) is light-impermeable and is disposed such that the corresponding light source (9) is screened in a light-impermeable manner by the anode (2) or the cathode (7) in a direction along the axis of the microlenses (9).

8. Microlens array according to one of the preceding claims, **characterised in that** a light-permeable electrode made of electrically conductive material is disposed between the optically transparent basic body (8) and the at least one light source (8) or a light-impermeable electrode made of electrically conductive material is disposed on the opposite side of the light source.

9. Microlens array according to one of the preceding claims, **characterised in that** the anode or cathode (7) of at least one light source serves, on the image side, at the same time as light-impermeable aperture layer in order to prevent light radiation in the direction of the image side.

10. Microlens array according to one of the preceding claims, **characterised by** a conductive, transparent layer (2) which is arranged on a side of the microlens array orientated away from the microlenses and/or the side of the microlens array which has the microlenses, wherein the conductive, transparent layer (2) comprises or consists of indium-tin oxide (ITO), ZnO or thin metal layers.

11. Microlens array according to one of the preceding claims, **characterised by** at least one light-impermeable electrode (2) or at least one light-absorbing aperture layer (3) which is disposed such that both the light radiation of the light source and the reflection of the light emitted from the light sources (6) of all the elements apart from the object to be imaged is prevented in the direction of the image side.

12. Microlens array according to one of the preceding claims, **characterised in that** the optically transparent basic body (8) is configured to be thin such that the light emitted from the light sources (6), with total reflection once on the object-side interface of the optically transparent basic body (8), cannot impinge upon an adjacent microlens (9).

13. Method for producing a microlens array according to one of the claims 1 to 12, a large number of microlenses being disposed or moulded in an array arrangement on, at, in and/or behind a first side of a flat, optically transparent basic body and at least one light source being disposed at, in or on the optically transparent basic body such that the projection of the at least one light source is in the direction of the optical main axes of the microlenses onto the first side between the lenses.

## Revendications

1. Matrice de micro-lentilles pour la représentation d'un objet à extension plane avec un corps de base plat transparent (8) dans un plan d'image, qui s'étend dans un plan, une pluralité de micro-lentilles (9) disposées sur ou dans un premier côté du corps de base transparent, qui sont écartées entre elles et présentent des plans de lentilles parallèles à un plan, et une pluralité de sources de lumière (6) qui sont disposées sur côté du corps de base transparent (8) opposé au premier côté, les projections des sources de lumière (6) se trouvant dans la direction des axes optiques des micro-lentilles (9) sur le premier côté du corps de base transparent (8) entre les micro-lentilles (9) et une direction principale d'émission de lumière des sources de lumière étant parallèle aux axes optiques des micro-lentilles (9) en direction de l'objet à représenter, la matrice de micro-lentilles se trouvant entre le plan d'image et la surface de l'objet.

2. Matrice de micro-lentilles selon la revendication précédente, **caractérisée en ce qu'**au moins une source de lumière (6) comprend une source de lumière plate, une diode électroluminescente organique, une diode à luminescence organique, un film EL structuré ou des LED « Quantum-Dot ».

3. Matrice de micro-lentilles selon l'une des revendications précédentes, **caractérisée en ce que** le rapport entre la longueur d'arête axiale du composite de la matrice de micro-lentilles et du corps de base transparent (8) et la longueur d'arête latérale est inférieur à 1:3, de préférence inférieure à 1:25 ou inférieur à 1:1000.

4. Matrice de micro-lentilles selon l'une des revendications précédentes, **caractérisée en ce que** l'au moins une source de lumière (6) est conçue de manière plane mais émet de la lumière uniquement dans des zones disposées de manière matricielle.

5. Matrice de micro-lentilles selon l'une des revendications précédentes, **caractérisée en ce que** la matrice de micro-lentilles comprend au moins une source de lumière (6) et **en ce qu'**au moins une des sources de lumière est entourée d'une couche de masquage (3) dans un plan parallèle au plan de sa surface de sortie de lumière, qui, à l'exception de la zone angulaire spatiale côté objet, et dans la direction de projection des micro-lentilles (9), est opaque à la lumière le long de ses axes optiques ou **en ce que** la matrice de micro-lentilles comprend au moins deux sources de lumière (6) et **en ce qu'**au moins deux des au moins deux sources de lumière sont entourées par une couche de masquage (3) s'étendant entre elles dans un plan parallèle au plan de leur disposition, qui, à l'exception de la zone angulaire spatiale côté objet, et dans la direction de projection des micro-lentilles (9), est opaque à la lumière le long de ses axes optiques.

6. Matrice de micro-lentilles selon l'une des revendications précédentes, **caractérisée en ce que** la couche de masquage (3) comprend des matériaux structurables non électro-conducteurs ou au moins un polymère « Black Matrix » avec une résistance volumique élevée ou est constituée de ceux-ci.

7. Matrice de micro-lentilles selon l'une des revendications précédentes, **caractérisée en ce que** l'au moins une source de lumière (9) est mise en contact par l'intermédiaire d'au moins une anode (2) et d'au moins une cathode (7) en tant qu'électrodes, l'au moins une anode (2) et l'au moins une cathode (7) étant opaques et disposées de façon à ce que la source de lumière (9) correspondante soit protégée de manière opaque par l'anode (2) ou la cathode (7) dans une direction le long de l'axe des micro-lentilles (9).

8. Matrice de micro-lentilles selon l'une des revendications précédentes, **caractérisée en ce que**, entre le corps de base transparent (8) et l'au moins une source de lumière (9) se trouve une électrode opaque constituée d'un matériau électro-conducteur ou sur le côté opposé à la source de lumière, se trouve une électrode opaque en matériau électro-conducteur.

9. Matrice de micro-lentilles selon l'une des revendications précédentes, **caractérisée en ce que**, du côté de l'image, l'anode ou la cathode (7) d'au moins une source de lumière sert également de couche de masquage opaque afin d'empêcher une émission de lumière dans la direction du côté de l'image.

10. Matrice de micro-lentilles selon l'une des revendications précédentes, **caractérisée par** une couche transparente (2) électro-conductrice disposée sur le côté, opposé aux micro-lentilles ou comprenant les micro-lentilles, de la matrice de micro-lentilles, qui comprend de l'oxyde de zinc d'indium (ITO), du ZnO ou de couches métalliques minces ou est constituée de ceux-ci.

11. Matrice de micro-lentilles selon l'une des revendications précédentes, **caractérisée par** une électrode (2) opaque ou au moins une couche de masquage (3) absorbant la lumière, qui est disposée de façon à ce que l'émission de lumière de la source de lumière ainsi que la réflexion de la lumière émise par les sources de lumière (6) soient empêchées par tous les éléments excepté l'objet à représenter en direction du côté de l'image.

12. Matrice de micro-lentilles selon l'une des revendications précédentes, **caractérisée en ce que** le corps de base transparent (8) est conçu de manière mince de façon à ce que la lumière émise par les sources de lumière (6) ne puisse pas arriver, dans le cas d'une réflexion totale unique sur la surface limite côté objet du corps de base transparent (8), dans une micro-lentille (9) adjacente.

13. Procédé de fabrication d'une matrice de micro-lentilles selon l'une des revendications 1 à 12, une pluralité de micro-lentilles étant disposée ou formée dans une disposition en matrice sur, dans et/ou derrière un premier côté d'un corps de base transparent plat et au moins une source de lumière est disposée dans ou sur le corps de base transparent de façon à ce que la projection de l'au moins une source de lumière se trouve en direction des axes optiques principaux des micro-lentilles sur le premier côté entre les lentilles.
